(19) Europäisches Patentamt
European Patent Office
Office européen des brevets

(11) Veröffentlichungsnummer: **0 294 333 B1**

(12) **EUROPÄISCHE PATENTSCHRIFT**

(45) Veröffentlichungstag der Patentschrift: **17.03.93**

(51) Int. Cl.$^5$: **G03F 7/029**

(21) Anmeldenummer: **88810347.0**

(22) Anmeldetag: **30.05.88**

# (54) Kationisch polymerisierbare Gemische enthaltend ausgewählte Härter.

(30) Priorität: **05.06.87 CH 2147/87**

(43) Veröffentlichungstag der Anmeldung:
**07.12.88 Patentblatt 88/49**

(45) Bekanntmachung des Hinweises auf die Patenterteilung:
**17.03.93 Patentblatt 93/11**

(84) Benannte Vertragsstaaten:
**AT BE CH DE ES FR GB IT LI NL SE**

(56) Entgegenhaltungen:
**EP-A- 0 265 373**

(73) Patentinhaber: **CIBA-GEIGY AG**
**Klybeckstrasse 141**
**CH-4002 Basel(CH)**

(72) Erfinder: **Meier, Kurt, Dr.**
**Im Kirschgarten 35**
**CH-4102 Binningen(CH)**
Erfinder: **Salvin, Roger Pierre-Elie, Dr.**
**Lörracherstrasse 17**
**W-7858 Weil am Rhein(DE)**

**EP 0 294 333 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft kationisch polymerisierbare Gemische enthaltend ausgewählte Härter, neue Härter für kationisch polymerisierbare Materialien, aktivierte polymerisierbare Gemische, sowie die Verwendung dieser Gemische zum Herstellen von Beschichtungen.

Die Verwendung von Metallocenkomplexsalzen als Härter für kationisch und/oder radikalisch polymerisierbares Material ist an sich bekannt.

In den EP-A 94,915 und 109,851 werden härtbare Gemische beschrieben, die kationisch polymerisierbare Materialien, bevorzugt Epoxidharze, und als Härter Metallocenkomplexsalze enthalten.

Aus der EP-A 126,712 sind Kombinationen von kationisch und/oder radikalisch polymerisierbarem Material, einem Eisen-Aren-Komplexsalz und einem Oxidationsmittel bekannt.

Die EP-A 152,377 beschreibt Kombinationen von kationisch und/oder radikalisch polymerisierbarem Material, ausgewählten Eisen-Aren-Komplexsalzen, Sensibilisatoren und gegebenenfalls Oxidationsmitteln.

In allen diesen Publikationen werden als Anionen des Metallocenkomplexsalzes komplexe Halogenide vorgeschlagen. Beispiele dafür sind $BF_4^-$, $PF_6^-$, $AsF_6^-$ und $SbF_6^-$.

Aus der EP-A 221,010 sind Kombinationen von radikalisch polymerisierbaren Materialien, ausgewählten Eisen-Aren-Komplexsalzen und einem Photoinitiator vom Typ der $\alpha$-Spalter bekannt. Das Anion der Eisen-Aren-Komplexsalze wird danach ausgewählt aus der Gruppe bestehend aus Halogen, Nitrat, Sulfat, Phosphat, Perchlorat oder einem komplexen Halogenid.

Bei der Härtung von Gemischen enthaltend feste oder hochviskose Epoxidharze und Metallocenkomplexsalze mit komplexen Metall- oder Nichtmetallhalogenidanionen können Probleme auftreten, da die Härter im allgemeinen sehr reaktiv sind und zu einer inhomogenen Vernetzungsdichte führen können. Dies macht sich dann durch Blasenbildung im gehärteten Produkt beim Lötvorgang bemerkbar und ein Einsatz als Lötstopplack ist in der Regel nicht mehr möglich. In solchen Fällen müssen daher die Härtungsbedingungen sehr sorgfältig kontrolliert werden.

Ferner besteht auf dem Elektroniksektor die Tendenz nach Produkten, die möglichst wenig freies oder hydrolysierbares Halogen aufweisen. Es wäre daher wünschenswert, wenn man neben den Härtern mit komplexen Metall-oder Nichtmetallhalogenidanionen, aus denen sich durch Hydrolyse Halogen abspalten lässt, noch weitere Verbindungen zur Verfügung hätte, die weniger hydrolyseempfindlich sind und die eine vergleichbar hohe Reaktivität wie die vorbekannten Härter aufweisen.

Für eine Reihe von Anwendungen sind hohe Glasumwandlungstemperaturen des gehärteten Produktes gefragt; beispielsweise bei der Verwendung als Lötstopplack, bei der hohe Temperaturbeständigkeit gefordert wird. Es wurde jetzt eine ausgewählte Klasse von Härtern gefunden, die in Kombination mit kationisch polymerisierbaren Verbindungen härtbare Gemische mit den oben erwähnten Vorteilen ergeben.

Die vorliegende Erfindung betrifft Gemische enthaltend

a) eine kationisch polymerisierbare Verbindung und
b) eine Verbindung der Formel I

$$[R^1(Fe^{II}R^2)_a]_q^{\oplus an}\ an\ X^{\ominus q} \qquad (I),$$

worin a 1 oder 2 ist, n 1 oder 2 darstellt, $R^1$ ein gegebenenfalls substituiertes $\pi$-Aren ist, $R^2$ ein gegebenenfalls substituiertes $\pi$-Aren oder Cyclopentadienylanion oder Indenylanion bedeutet, q eine ganze Zahl von 1 bis 3 ist und X $FSO_3^-$ oder ein q-wertiges Anion einer organischen Sulfonsäure oder einer Carbonsäure ist, mit der Massgabe, dass $R^1$ auch ein polymerer, aromatischer Ligand sein kann und dass in einem solchen Fall a eine Zahl ist, die der mittleren Anzahl der komplexierten Gruppen des Polymerliganden entspricht.

Als Komponente a) lassen sich im Rahmen dieser Erfindung beispielsweise A) kationisch polymerisierbare, ethylenisch ungesättigte Verbindungen, B) kationisch polymerisierbare, heterocyclische Verbindungen und C) Methylolverbindungen einsetzen.

Beispiele für Verbindungen dieses Typs findet man in der EP-A 94,915.

Bevorzugte Komponenten a) sind kationisch polymerisierbare, heterocyclische Verbindungen, Vinylester und Vinylether. Bevorzugt werden Divinylether von $C_2$-$C_{12}$ aliphatischen Diolen und von Polyethylen-oder Polypropylenglykolen, sowie von Dimethylolcyclohexanen.

Beispiele für Verbindungen dieses Typs sind die Divinylether von Ethylenglykol, Trimethylen-1,3-diol, 1-Methylpropan-1,3-diol, Octamethylen-1,8-diol, Diethylenglykol, Triethylenglykol, Tetramethylen-1,4-diol, $HO(CH_2)_2O(CH_2)_4O(CH_2)_2OH$ und Bis-1,4-methylolcyclohexan.

Besonders bevorzugte Komponenten a) sind Epoxidharze, insbesondere solche mit mindestens zwei 1,2-Epoxidgruppen im Molekül. Zu diesen Verbindungen zählen beispielsweise:

I) Polyglycidyl- und Poly-($\beta$-methylglycidyl)-ester erhältlich durch Umsetzung einer Verbindung mit mindestens zwei Carboxylgruppen im Molekül und Epichlorhydrin bzw. Glyzerindichlorhydrin bzw. $\beta$-Methyl-epichlorhydrin. Die Umsetzung erfolgt zweckmässig in der Gegenwart von Basen.

Als Verbindung mit mindestens zwei Carboxylgruppen im Molekül können aliphatische Polycarbonsäuren verwendet werden. Beispiele für diese Polycarbonsäuren sind Oxalsäure, Bernsteinsäure, Glutarsäure, Adipinsäure, Pimelinsäure, Korksäure, Azelainsäure, Sebazinsäure oder dimerisierte bzw. trimerisierte Linolsäure.

Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure.

Weiterhin können aromatische Polycarbonsäuren Verwendung finden, wie beispielsweise Phthalsäure, Isophthalsäure oder Terephthalsäure.

II) Polyglycidyl- oder Poly-($\beta$-methylglycidyl)-ether erhältlich durch Umsetzung einer Verbindung mit mindestens zwei freien alkoholischen Hydroxygruppen und/oder phenolischen Hydroxygruppen und einem geeignet substituierten Epichlorhydrin unter alkalischen Bedingungen, oder in Anwesenheit eines sauren Katalysators und anschliessender Alkalibehandlung.

Ether dieses Typs leiten sich beispielsweise ab von acyclischen alkoholen, wie Ethylenglykol, Diethylenglykol und höheren Poly-(oxyethylen)-glykolen, Propan-1,2-diol oder Poly-(oxypropylen)-glykolen, Propan-1,3-diol, Butan-1,4-diol, Poly-(oxytetramethylen)-glykolen, Penta-1,5-diol, Hexan-1,6-diol, Hexan-2,4,6-triol, Glycerin, 1,1,1-Trimethylolpropan, Pentaerythrit, Sorbit, sowie von Polyepischlorhydrinen.

Sie leiten sich aber auch beispielsweise ab von cycloaliphatischen Alkoholen wie 1,3-oder 1,4-Dihydroxycyclohexan, Bis-(4-hydroxycyclohexyl)-methan, 2,2-Bis(4-hydroxycyclohexyl)-propan oder 1,1-Bis-(hydroxymethyl-cyclohex-3-en.

Die Epoxidverbindungen können sich auch von einkernigen Phenolen ableiten, wie beispielsweise von Resorcin oder Hydrochinon; oder sie basieren auf mehrkernigen Phenolen wie beispielsweise auf Bis-(4-hydroxyphenyl)-methan, 4,4'-Dihydroxydiphenyl, Bis-(4-hydroxyphenyl)-sulfon, 1,1,2,2-Tetrakis-(4-hydroxyphenyl)-ethan, 2,2-Bis-(4-hydroxyphenyl)-propan, 2,2-Bis-(3,5-dibrom-4-hydroxyphenyl)-propan sowie auf Novolaken erhältlich durch Kondensation von Aldehyden, wie beispielsweise Formaldehyd, Acetaldehyd, Chloral oder Furfuraldehyd mit Phenolen wie Phenol, oder mit Phenolen, die im Kern mit Chloratomen oder $C_1$-$C_9$Alkylgruppen substituiert sind, wie beispielsweise 4-Chlorphenol, 2-Methylphenol oder 4-tert.-Butylphenol oder erhältlich durch Kondensation mit Bisphenolen, so wie oben beschrieben.

III) Poly-(S-glycidyl) Verbindungen, insbesondere Di-S-glycidylderivate, die sich von Dithiolen, wie beispielsweise Ethan-1,2-dithiol oder Bis-(4-merkaptomethylphenyl)-ether ableiten.

IV) Cycloaliphatische Epoxidharze, wie Bis-(2,3-epoxicyclopentyl)-ether, 2,3-Epoxicyclopentylglycidylether oder 1,2-Bis-(2,3-epoxycyclopentyloxy)-ethan oder 3,4-Epoxicyclohexylmethyl-3',4'-epoxicyclohexancarboxylat.

Es lassen sich aber auch Epoxidharze verwenden, bei denen die 1,2-Epoxidgruppen an unterschiedliche Heteroatome bzw. funktionelle Gruppen gebunden sind; zu diesen Verbindungen zählen beispielsweise der Glycidylether-glycidylester der Salicylsäure.

Falls gewünscht, kann eine Mischung von Epoxidharzen in den erfindungsgemässen Gemischen verwendet werden.

Ganz besonders bevorzugte kationisch polymerisierbare Verbindungen sind hochviskose oder insbesondere feste Epoxidharze, beispielsweise feste Diglycidylether auf Bisphenol-Basis oder glycidylierte Phenol- oder Kresol-Novolake. Darunter versteht man im allgemeinen Verbindungen, die in ungehärtetem Zustand eine Glasumwandlungstemperatur von mehr als 0 ° C aufweisen.

Beispiele dafür sind feste Diglycidylether auf Bisphenol-F-Basis und insbesondere auf Bisphenol-A-Basis und glycidylierte Phenol-Formaldehyd-Novolake oder o-Kresol-Formaldehyd-Novolake.

Unter "$\pi$-Aren $R^1$ und $R^2$" ist im Rahmen dieser Beschreibung ein $\pi$-Ligand des Fe-II-Zentralatoms zu verstehen, wobei dieser Ligand eine carbocyclisch-aromatische Gruppe oder eine heterocyclisch-aromatische Gruppe sein kann.

Als $\pi$-Arene $R^1$ und $R^2$ kommen insbesondere carboxyclisch-aromatischeGruppen mit 6 bis 24 Kohlenstoffatomen oder heterocyclisch-aromatische (heteroaromatische) Gruppen mit 3 bis 30 Kohlenstoffatomen in Betracht, wobei diese Gruppen gegebenenfalls durch gleiche oder verschiedene einwertige Reste, wie Halogenatome, vorzugsweise Chlor-oder Bromatome, oder $C_1$-$C_8$-Alkyl, $C_1$-$C_8$-Alkoxy-, Cyan-, $C_1$-$C_8$-Alkylthio-, $C_2$-$C_6$-Monocarbonsäurealkylester-, Phenyl-, $C_2$-$C_5$-Alkanoyl- oder Benzoylgruppen einfach oder mehrfach substituiert sein können. Diese $\pi$-Arengruppen können einkernige, kondensierte mehrkernige oder unkondensierte mehrkernige Systeme darstellen, wobei in den zuletzt genannten Systemen die Kerne direkt

oder über Brückenglieder wie -S-oder -O- verknüpft sein können.

$R^2$ kann auch ein Indenylanion und insbesondere ein Cyclopentadienylanion sein, wobei auch diese Anionen gegebenenfalls durch gleiche oder verschiedene einwertige Reste wie $C_1$-$C_8$-Alkyl-, $C_2$-$C_6$-Monocarbonsäurealkylester-, Cyan-, $C_2$-$C_5$-Alkanoyl- oder Benzoylgruppen einfach oder mehrfach substituiert sein können.

Die Alkyl-, Alkoxy-, Alylthio-, Monocarbonsäurealkylester- und Alkanoylsubstituenten können dabei geradkettig oder verzweigt sein. Als typische Alkyl-, Alkoxy-, Alkylthio-, Monocarbonsäurealkylester-bzw. Alkanoylsubstituenten seien Methyl, Ethyl, n-Propyl, Isopropyl, n-Butyl, sek.-Butyl, tert.-Butyl, n-Pentyl, n-Hexyl und n-Octyl, Methoxy, Ethoxy, n-Propoxy, Isopropoxy, N-Butoxy, n-Hexyloxy und n-Octyloxy, Methylthio, Ethylthio, n-Propylthio, Isopropylthio, n-Butylthio, n-Pentylthio und n-Hexylthio, Carbonsäuremethyl-, -ethyl-, -n-propyl-, -isopropyl-, -n-butyl- und -n-pentylester bzw. Acetyl, Propionyl, Butyryl und Valeroyl genannt. Dabei sind Alkyl-, Alkoxy-, Alkylthio- und Monocarbonsäurealkylestergruppen mit 1 bis 4 und insbesondere 1 oder 2 Kohlenstoffatomen in den Alkylteilen sowie Alkanoylgruppen mit 2 oder 3 Kohlenstoffatomen bevorzugt. Als substituierte $\pi$-Arene oder substituierten Indenyl- oder Cyclopentadienylanionen werden solche bevorzugt, die einen oder zwei der obengenannten Substituenten, insbesondere Methyl-, Ethyl-, n-Propyl, Isopropyl, Methoxy- oder Ethoxygruppen, enthalten.

Als $R^1$ und $R^2$ können gleiche oder verschiedene $\pi$-Arene vorliegen. $R^1$ kann darüber hinaus auch ein polymerer Ligand mit aromatischen Resten sein.

$R^1$ als aromatischer, polymerer Ligand ist vorzugsweise ein Polymer mit carbocyclisch-aromatischen Resten. Bevorzugt werden Polystyrol, Copolymere von Polystyrol mit Butadien und Poly-$\alpha$-methylstyrol. Die Molekulargewichte der Polymerliganden bewegen sich im Rahmen der üblicherweise erhältlichen Polymeren. Für Polystyrol liegen die Molekulargewichte in der Regel zwischen $10^5$ und $10^6$. In der Regel sind 1-50 Mol % der aromatischen Gruppen, bezogen auf die Gesamtzahl pro Polymermolekül, mit $Fe^{II}$ komplexiert. $R^2$ ist in solchen Fällen bevorzugt Cyclopentadienylanion. Die Zahl a entspricht bei polymeren Liganden der mittleren Anzahl der durch $Fe^{II}$ komplexierten Reste eines Polymermoleküls. Bevorzugte Liganden $R^1$ sind monomere $\pi$-Arene.

Als heteroaromatische $\pi$-Arene eignen sich insbesondere ein oder zwei S-, N- und/oder O-Atome enthaltende Systeme.

Heteroaromatische $\pi$-Arene, die ein oder zwei S- und/oder O-Atome enthalten, sind bevorzugt.

Beispiele für geeignete $\pi$-Arene sind Benzol, Toluol, Xylole, Ethylbenzol, Cumol, Methoxybenzol, Ethyoxybenzol, Dimethoxybenzol, p-Chlortoluol, m-Chlortoluol, Chlorbenzol, Brombenzol, Dichlorbenzol, Trimethylbenzol, Trimethoxybenzol, Naphthalin, 1,2-Dihydronaphthalin, 1,2,3,4-Tetrahydronaphthalin, Methylnaphthalin, Methoxynaphthalin, Ethoxynaphthalin, Chlornaphthalin, Bromnaphthalin, Biphenyl, Stilben, Inden, 4,4'-Dimethylbiphenyl, Fluoren, Phenanthren, Anthracen, 9,10-Dihydroanthracen, Triphenyl, Pyren, Perylen, Naphthacen, Coronen, Thiophen, Chromen, Xanthen, Thioxanthen, Benzofuran, Benzothiophen, Naphthothiophen, Thianthren, Diphenylenoxyd, Diphenylensulfid, Acridin und Carbazol.

Beispiele für Anionen substituierter Cyclopentadiene sind die Anionen des Methyl-, Ethyl-, n-Propyl- und n-Butylcyclopentadiens, die Anionen des Dimethylcyclopentadiens, der Cyclopentadiencarbonsäuremethyl- und -ethylester sowie des Acetylcyclopentadiens, Propionylcyclopentadiens, Cyancyclopentadiens und Benzoylcyclopentadiens. Bevorzugte Anionen sind das Anion des unsubstituierten Indens und insbesondere des unsubstituierten Cyclopentadiens.

Wenn a 2 ist, stellt $R^2$ vorzugsweise je das gegebenenfalls substituierte Indenylanion oder insbesondere Cylopentadienylanion dar.

$X^{\ominus q}$ ist $FSO_3^-$ oder bevorzugt das q-wertige Anion einer organischen Sulfonsäure oder einer Carbonsäure. Darunter versteht man ganz allgemein eine aliphatische , cycloaliphatische, carbocyclisch-aromatische, heterocyclisch-aromatische oder araliphatische Sulfon- oder Carbonsäure.

Die Anionen können substituiert oder unsubstituiert sein. Bevorzugt sind Sulfon- oder Carbonsäuren mit geringer Nucleophilie, beispielsweise teil-oder perfluorierte Derivate oder in Nachbarstellung zur jeweiligen Säuregruppe substituierte Derivate.

Beispiele für Substituenten sind Halogen, wie Chlor oder besonders Fluor, Alkyl, wie Methyl, Ethyl oder n-Propyl, oder Alkoxy, wie Methoxy, Ethoxy oder n-Propoxy.

Beispiele für aliphatische Sulfonsäuren sind Methan-, Ethan-, n-Propan-, n-Butan- und n-Hexansulfonsäure oder die entsprechenden teil- oder perfluorierten Derivate.

Beispiele für aliphatische Carbonsäuren sind Ameisensäure, Essigsäure, Propionsäure, Buttersäure, Pivalinsäure, Capronsäure, 2-Ethylhexylcarbonsäure und Fettsäuren, wie Laurinsäure, Myristinsäure oder Stearinsäure, sowie die teil- oder perfluorierten Derivate dieser Säuren.

Beispiele für cycloaliphatische Sulfon- oder Carbonsäuren sind Cyclohexansulfonsäure, Cyclohexancarbonsäure, Campher-10-sulfonsäure oder deren teil- oder perfluorierten Derivate.

Beispiele für carbocyclisch-aromatische Sulfonsäuren sind Benzol-, Toluol-, Ethylbenzol-, Isopropylbenzol-, Dodecylbenzol- oder Dimethylbenzolsulfonsäure, 2,4,6-Triisopropylbenzolsulfonsäure, 2,4,6-Trimethylbenzolsulfonsäure, Naphthalinsulfonsäure, -disulfonsäuren oder -trisulfonsäuren und die entsprechenden alkylierten oder teil- oder perfluorierten Derivate dieser Sulfonsäuren.

Beispiele für heterocyclisch-aromatische Sulfonsäuren sind Pyridin-, Thiophen- oder Pyrrolsulfonsäure und die entsprechenden teil- oder perfluorierten Derivate dieser Säuren.

Beispiele für araliphatische Sulfonsäuren sind Benzylsulfonsäure, α-Methylbenzylsulfonsäure und die entsprechenden teil- oder perfluorierten Derivate dieser Verbindungen.

Beispiele für carbocyclisch-aromatische Carbonsäuren sind Benzoesäure, Toluol-, Ethylbenzol-, Isopropylbenzol- oder Dimethylbenzolcarbonsäure, Naphthalincarbonsäure oder Anthracencarbonsäure und die entsprechenden teil- oder perfluorierten Derivate dieser Verbindungen.

Beispiele für heterocyclisch-aromatische Carbonsäuren sind Pyridin-, Thiophen- oder Pyrrolcarbonsäure sowie die entsprechenden teil- oder perfluorierten Derivate dieser Verbindungen.

Beispiele für araliphatische Carbonsäuren sind Benzylcarbonsäure, α-Methylbenzylcarbonsäure und Zimtsäure, sowie die entsprechenden teil-oder perfluorierten Derivate dieser Verbindungen.

Vorzugsweise handelt es sich bei $X^{\ominus q}$ um das einwertige Anion einer organischen Sulfonsäure, insbesondere einer Teilfluor- oder Perfluorsulfonsäure. Diese Anionen zeichnen sich durch eine besonders geringe Nucleophilie aus.

Bevorzugt werden Gemische, worin Komponente b) eine Verbindung der Formel I ist und $X^{\ominus q}$ ein einwertiges Anion einer aliphatischen, teilfluoraliphatischen oder perfluoraliphatischen Sulfonsäure oder einer aromatischen, teilfluoraromatischen oder perfluoraromatischen Sulfonsäure ist.

Besonders bevorzugt werden Gemische, worin Komponente b) eine Verbindung der Formel I ist und $X^{\ominus q}$ ausgewählt wird aus der Gruppe bestehend aus $CF_3SO_3^-$, $C_2F_5SO_3^-$, n-$C_3F_7SO_3^-$, n-$C_4F_9SO_3^-$, n-$C_6F_{13}SO_3^-$, n-$C_8F_{17}SO_3^-$ und $C_6F_5SO_3^-$.

Bevorzugt werden härtbare Gemische enthaltend als Komponente b) eine Verbindung der Formel Ia

$[R^1FeIIR^2]^{\oplus n}\ n\ X^{\ominus}$ (Ia),

worin $R^1$ ein π-Aren ist, $R^2$ ein π-Aren oder ein Cyclopentadienylanion bedeutet, n die oben definierte Bedeutung besitzt und $X^{\ominus}$ ein Anion einer organischen Sulfonsäure darstellt.

Besonders bevorzugte härtbare Gemische enthalten als Komponente b) eine Verbindung der Formel I oder Ia, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder Perfluorphenylsulfonat ist.

Weitere bevorzugte Gemische enthalten als Komponente a) ein festes Epoxidharz und als Komponente b) eine Verbindung der Formel Ia, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder ein Perfluorphenylsulfonat ist, insbesondere jedoch ein Trifluormethansulfonat oder ein Nonafluorbutansulfonat.

Für die Vertragsstaaten AT, BE, CH, LI, NL, SE müssen alle Verbindungen der Formel I als neu gelten, mit Ausnahme von:

1,4-Dimethylbenzol-cyclopentadienyl-eisen-(II)-trifluormethansulfonat und

9,9-Dimethylfluoren-cyclopentadienyl-eisen-(II)-fluorsulfonat. Diese Verbindungen sind in Inorg. Chem., 22, 4047 (1983) und 23, 2633 (1984) bzw. in Nouv. J. Chim. 8(6), 381 (1984) beschrieben. Diese Veröffentlichungen beschreiben die pyrolytisch induzierte Ligandenaustauschreaktion an Eisen-Aren Komplexen bzw. die Herstellung der Verbindungen, nicht jedoch deren Verwendung als Härter für kationisch polymerisierbare Materialien.

Die Erfindung betrifft also auch die Verbindungen der Formel I mit Ausnahme von 1,4-Dimethylbenzol-cyclopentadienyl-eisen-(II)-trifluormethansulfonat und 9,9-Dimethylfluoren-Cyclopentadienyl-eisen-(II)-fluorsulfonat.

Beispiele für besonders bevorzugte Verbindungen sind:

(Toluol)(cyclopentadienyl)eisen(II)-trifluormethansulfonat, (Ethylbenzol)(cyclopentadienyl)eisen(II)-trifluormethansulfonat, (Cumol)(cyclopentadienyl)eisen(II)-trifluormethansulfonat, (Methoxybenzol)(cyclopentadienyl)-eisen(II)-trifluormethansulfonat, (Methylnaphthalin)(cyclopentadienyl)eisen(II)-trifluormethansulfonat, (Methoxynaphthalin)(cyclopentadienyl)eisen(II)-trifluormethansulfonat, (Pyren)(cyclopentadienyl)eisen(II)-trifluormethansulfonat, (Perylen)(cyclopentadienyl)eisen(II)-trifluormethansulfonat, (Stilben)(cyclopentadienyl)-

eisen(II)-trifluormethansulfonat, (Diphenylenoxid)(cyclopentadienyl)eisen(II)-tirfluormethansulfonat, (Diphenylensulfid)(cyclopentadienyl)eisen(II)-trifluormethansulfonat, (Fluoren)(cyclopentadienyl)eisen(II)-trifluormethansulfonat, und die entsprechenden Nonofluorbutansulfonate, Tridecafluorhexansulfonate, Heptadecafluoroctansulfonate, Fluorsulfonate, Pentafluorphenylsulfonate und Trifluoracetate.

Die als Komponente a) eingesetzten Materialien sind an sich bekannt und grösstenteils im Handel erhältlich.

Die Verbindungen der Formel I werden in Analogie zu bekannten Verfahren hergestellt. Die Herstellung von Metallocenkomplexen dieses Typs mit komplexen Halogenidanionen ist beispielsweise in der EP-A 94,915 beschrieben.

Die Verbindungen der Formel I lassen sich in Abweichung von den dort beschriebenen Verfahren herstellen, indem man anstelle eines Anions eines komplexen Halogenids ein Anion der Säure $H_qX$ in an sich bekannter Weise einführt; dabei besitzen q und X die weiter oben definierte Bedeutung.

Die Einführung des Anions kann beispielsweise durch Umsetzung eines Metallocenhalogenids mit einer Säure $H_qX$ oder einem gelösten Salz einer solchen Säure erfolgen.

Die erfindungsgemässen härtbaren Gemische sind lichtempfindlich. Sie lassen sich in beliebiger Form erhalten, z.B. als homogene flüssige Gemische oder in homogener oder inhomogener Form. Homogene Produkte können in an sich bekannter Weise zum Beispiel durch Verflüssigung fester polymerisierbarer organischer Materialien, gegebenenfalls unter Zusatz geeigneter Lösungsmittel im Dunkeln oder unter rotem Licht, Erhitzen auf Temperaturen über ihrem Glasübergangspunkt, Zugabe des Initiators der Formel I und Abkühlung der entstandenen Gemische erhalten werden. Gewünschtenfalls kann man die so erhaltenen Produkte anschliessend zerkleinern. Inhomogene Produkte können beispielsweise durch Vermischen polymerisierbarer Materialien in Pulverform mit erfindungsgemässen Initiatoren erhalten werden.

Die erfindungsgemässen härtbaren Gemische sind bei Raumtemperatur in verhältnismässiger Dunkelheit, z.B. in rotem Licht, beträchtliche Zeit lagerfähig.

Je nach ihrer Zusammensetzung und ihrem Endzweck, z.B. zur Herstellung von Ueberzügen oder Filmen, können sie direkt heissgehärtet werden. In der Regel wird die direkte Heisshärtung bei Temperaturen von 130-220 ° C, insbesondere von 150-180 ° C, vorgenommen. Die Temperaturen zur direkten Heisshärtung liegen vorzugsweise nahe bei dm Zersetzungspunkt des eingesetzten Initiators. Vorzugsweise verwendet man bei der direkten Heisshärtung Initiatoren der Formel I, worin $R^1$ ein kondensierter aromatischer Kohlenwasserstoff ist. Die Heisshärtung ist normalerweise nach etwa 3 bis 10 Minuten vollständig.

Der Ausdruck "Härten" wie er hier gebraucht wird, bedeutet die Umwandlung der löslichen, entweder flüssigen oder schmelzbaren kationisch polymerisierbaren Verbindung in feste, unlösliche und unschmelzbare, dreidimensional vernetzte Produkte. Dies erfolgt in der Regel unter gleichzeitiger Formgebung zu Formkörpern, Imprägnierungen, Beschichtungen oder Verklebungen.

Besonders bevorzugt wird die zweistufige Polymerisation (Härtung), indem man zunächst den Initiator der Formel I durch Bestrahlung des härtbaren Gemisches mit aktinischem Licht aktiviert und dann die so erhaltenen aktivierten Vorstufen heisshärtet, wobei die Bestrahlungstemperatur unter der zum nachfolgenden Heisshärten angewandten Temperatur liegt. Diese aktivierten Vorstufen lassen sich normalerweise bei Temperaturen härten, die erheblich niedriger liegen als bei direktem Heisshärten erforderlich ist, vorteilhaft im Bereich von 80 bis 180 ° C, vorzugsweise von 100 bis 180 ° C. Diese zweistufige Härtung ermöglicht es auch, die Polymerisation auf besonders einfache und vorteilhafte Weise zu steuern. Zudem sind die aus den erfindungsgemässen härtbaren Gemischen erhältlichen aktivierten Vorstufen bei Raumtemperatur sogar im Licht beträchtliche Zeit lagerfähig, dies trifft besonders auf diejenigen Gemische zu, welche als Komponente a) ein hochviskoses oder festes Epoxidharz enthalten. Dieses Merkmal stellt einen weiteren wesentlichen Vorteil der zweistufigen Härtung und dieser aktivierten Vorstufen dar. Aus flüssigen erfindungsgemässen härtbaren Gemischen erhältliche aktivierte Vorstufen besitzen im allgemeinen im Licht nur begrenzte Lagerfähigkeit und werden zweckmässig direkt weiterverwendet.

Die Bestrahlung der härtbaren Gemische zur Herstellung der aktivierten Vorstufen erfolgt zweckmässig mit aktinischem Licht, vorzugsweise einer Wellenlänge von 200 bis 600 nm. Als Lichtquellen eignen sich beispielsweise Xenonlampen, Argonlampen, Wolframlampen, Kohlelichtbögen, Metallhalogenid- und Metallichtbogenlampen, wie Niedrerdruck-, Mitteldruck- und Hochdruckquecksilberlampen oder auch Laser, wie Argon- oder Kryptonionen-Laser. Vorzugsweise wird die Bestrahlung mit Metallhalogenid- oder Hochdruckquecksilberlampen sowie mit Argon- oder Kryptonionen-Lasern durchgeführt. Die Bestrahlungszeit hängt von verschiedenen Faktoren ab, einschliesslich z.B. dem polymerisierbaren organischen Material, der Art der Lichtquelle und deren Abstand vom bestrahlten Material. Die Bestrahlungszeit beträgt vorzugsweise 10 bis 60 Sekunden.

Das Erhitzen der belichteten Zusammensetzungen kann in herkömmlichen Konvektionsöfen stattfinden. Sind kurze Erhitzungs- oder Reaktionszeiten erforderlich, so kann das Erhitzen durch Belichtung mit

beispielsweise IR-Strahlung, IR-Lasern oder Mikrowellengeräten erfolgen.

Im allgemeinen liegt die Härtungstemperatur bei der direkten Heisshartung oder beim thermischen Schritt der zweistufigen Polymerisation über derjenigen von Gemischen enthaltend die entsprechenden Metalloceninitiatoren mit Anionen komplexer Metall- oder Nichtmetallhalogenide.

Obwohl die Härter der Formel I in der Epoxidmatrix also in der Regel weniger reaktiv sind, entsteht im allgemeinen ein ausgehärtetes Produkt mit einer höheren Glasumwandlungstemperatur als bei der Härtung mit den Metallocenkomplexen enthaltend komplexe Halogenidanionen.

Dementsprechend betrifft die Erfindung auch das gehärtete Produkt erhältlich durch

i) direktes Heisshärten des härtbaren Gemisches, wie oben definiert oder durch ii) zweistufige Polymerisation des härtbaren Gemisches, wie oben definiert.

Ferner betrifft die Erfindung auch aktivierte härtbare Gemische, die durch Bestrahlung härtbarer Gemische, die ein kationisch polymerisierbares organisches Material a) und mindestens eine Verbindung der Formel I enthalten, mit aktinischem Licht bei einer Temperatur, die unter der zum Heisshärten des härtbaren Gemisches bei der Herstellung eines gehärteten Produkts augewendetem liegt, erhältlich sind. Das oben bezüglich der bevorzugten kationisch polymerisierbaren Materialien und Verbindungen der Formel I Gesagte gilt auch hier.

Die härtbaren Gemische und die daraus erhältlichen aktivierten Vorstufen können auch weitere, bekannte und üblicherweise in der Technik photopolymerisierbarer Materialien eingesetzte Zusatzstoffe enthalten.

Beispiele für solche Zusatzstoffe sind Pigmente, Farbstoffe, Füllstoffe und Verstärkungsmittel, wie Glasfasern und sonstige Fasern, Flammhemmstoffe, Antistatika, Verlaufmittel, Antioxydantien und Lichtschutzmittel.

Selbstverständlich können die erfindungsgemässen Gemische auch Kombinationen von Initiatoren der Formel I und Sensibilisatoren enthalten. Insbesondere bei Verbindungen der Formel I, worin $R^1$ ein gegebenenfalls substituiertes Benzolderivat ist, beobachtet man bei Zugabe von Sensibilisatoren in der Regel eine Steigerung der Lichtempfindlichkeit. Beispiele für geeignete Sensibilisatoren findet man in der EP-A-152,377. Ferner können in den erfindungsgemässen Gemischen auch Kombinationen von Initiatoren der Formel I, Oxidationsmitteln und gegebenenfalls Sensibilisatoren für die Verbindungen I eingesetzt werden. Oxidationsmittel setzen in der Regel die Härtungstemperaturen herab und gestatten eine Verarbeitung unter milden Bedingungen. Geeignete Oxidationsmittel sind in der EP-A-126,712 erwähnt.

Zur Erhöhung der Lagerfähigkeit im Dunkeln können die härtbaren Gemische und aktivierten Vorstufen schwache organische Basen wie Nitrile, tertiäre Amine oder Harnstoffderivate enthalten. Um vorzeitige Reaktion durch unbeabsichtigte Belichtung zu vermeiden, kann man kleine Mengen UV-Absorptionsmittel und/oder organische Farbstoffe zusetzen.

Die erfindungsgemässen härtbaren Gemische und die daraus erhältlichen aktivierten Vorstufen eignen sich bevorzugt zur Herstellung von Oberflächenbeschichtungen auf unterschiedlichen Substraten.

Ganz besonders bevorzugt verwendet man die härtbaren Gemische mit hochviskosen oder festen Epoxidharzen als Komponente a). In dieser Ausführungsform lassen sich die härtbaren Gemische bevorzugt als Lötstoppmasken verwenden. Diese Verwendungen sind ebenfalls Gegenstand der vorliegenden Erfindung.

Geeignete Substrate sind beispielsweise Metalle, wie Aluminium, Stahl, Cadmium, Zink und bevorzugt Kupfer, Halbleiter, wie Silizium, Germanium oder GaAs, Keramik, Glas, Kunststoffe, Papier oder Holz und insbesondere metallkaschierte Lamiate, wie sie zur herstellung von Leiterplatten verwendet werden.

Wird bei der oben beschriebenen zweistufigen Polymerisation zunächst nur ein Teil der Beschichtung bildmässig belichtet, beispielsweise durch eine Maske hindurch bestrahlt, so können die unbelichteten Stellen nach einer anschliessenden kurzen Heisshärtung mit einem geeigneten Lösungsmittel entfernt werden. Die erfindungsgemässen härtbaren Gemische sind somit zur Reproduktion von Abbildungen oder zur Herstellung von Druckplatten und insbesondere gedruckten Schaltungen (Photoresists) nach an sich bekannten Methoden (siehe z.B. britische Patentschrift 1 495 746) geeignet.

Soll bei der Herstellung von Abbildungen die Lichtenergie bei der Photostrukturierung minimiert werden, beispielsweise bei der Herstellung von Lötstoppmasken mittels Laserbelichtung, so bietet sich ein mehrstufiges Härtungsverfahren an. In diesem Verfahren wird zunächst eine Struktur hergestellt, wobei eine möglichst geringe Strahlungsintensität eingesetzt werden kann, und anschliessend wird diese Struktur nachbehandelt, um deren Endeigenschaften zu verbessern.

Das Verfahren ist gekennzeichnet durch die Schritte

A) bildmässiges Belichten eines mit der erfindungsgemässen Zusammensetzung beschichteten Substrates mit aktinischem Licht,

B) Tempern der Anordnung bei erhöhter Temperatur, so dass in den bestrahlten Flächenanteilen eine Vorhärtung erfolgt,

C) Entwickeln der Anordnung durch Behandlung mit einem Lösungsmittel, so dass die vorgehärtete Zusammensetzung in den bestrahlten Flächenanteilen im wesentlichen auf dem Substrat verbleibt und in den unbestrahlten Flächenanteilen weggelöst wird,

D) ganzflächiges Belichten mit aktinischem Licht, und

E) thermische Nachbehandlung, um die Härtung des vorgehärteten Produktes zu vervollständigen.

Die Temperaturen bei Schritt B) und E) liegen vorzugsweise oberhalb von 130°C und die Härtungsdauern bei diesen Schritten betragen vorzugsweise mehr als 10 Minuten bei Schritt B) und mehr als 15 Minuten bei Schritt E). Die Strahlungsdosis in Schritt A) wird vorzugsweise so gewählt, dass in Kombination mit Schritt B) gerade eine ausreichende Vorhärtung erfolgt, so dass Schritt C) problemlos durchgeführt werden kann. Die einzelnen Parameter bei dieser Kombination lassen sich vom Fachmann anhand von Routinetests ermitteln.

Die erfindungsgemässen Gemische und die daraus erhältlichen aktivierten Vorstufen sind auch als Klebstoffe oder zur Herstellung von Kitten, Füllstoffen oder faserverstärkten Verbundstoffen und Schichtkörpern verwendbar.

Für die obigen Anwendungen enthalten die erfindungsgemässen härtbaren Zusammensetzungen oder die daraus erhältlichen aktivierten Vorstufen zweckmässig 0,1 bis 15 Gew.-%, vorzugsweise 0,5 bis 5 Gew.-%, bezogen auf das polymerisierbare organische Material a), mindestens einer Verbindung der Formel I.

Die folgenden Beispiele erläutern die Erfindung.

A) Herstellung der Härtungsinitiatoren

Beispiel 1: ($\eta^6$-Cumol)($\eta^5$-cyclopentadienyl)eisen(II)-trifluormethansulfonat:

Man rührt ein Gemisch aus 7,5 g Ferrocen, 0,27 g Aluminium, 5,4 g Aluminiumchlorid und 4,5 g Titantetrachlorid in 35 ml Cumol 2 Stunden bei 100°C. Das Gemisch wird auf Raumtemperatur abgekühlt und in 20 ml Salzsäure 32 %/100 g Eis gegossen, 2 Stunden gerührt und dann filtriert. Die wässrige, gelbbraune Phase wird abgetrennt und mit 6 g Trifluormethansulfonsäure versetzt. Das Produkt wird mit zweimal 50 ml Methylenchlorid extrahiert, die Methylenchloridlösung einmal mit 30 ml 10%-iger Natriumhydrogencarbonatlösung und einmal mit 50 ml Wasser gewaschen, durch Zugabe von 5 g Natriumsulfat getrocknet, filtriert und das Methylenchlorid abgedampft. Umkristallisation aus Methylenchlorid/Hexan liefert 12,25 g (78,5 % der Theorie) des oben genannten Komplexes: Schmelzpunkt 49°C.

Beispiel 2: ($\eta^6$-Cumol)($\eta^5$-cyclopentadienyl)eisen(II)-nona-fluorbutansulfonat:

Nach der in Beispiel 1 beschriebenen Methode hergestellt, wobei anstelle von Trifluormethansulfonsäure 13,5 g Kalium-nonafluorbutansulfonat eingesetzt werden. Man erhält 16,6 g (77 % der Theorie) des oben genannten Komplexes: Schmelzpunkt 45,5°C.

Beispiel 3: ($\eta^6$-Cumol)($\eta^5$-cyclopentadienyl)eisen(II)-pentafluorbenzolsulfonat:

Nach der in Beispiel 1 beschriebenen Methode hergestellt, wobei anstelle von Trifluormethansulfonsäure 10,8 g Natriumpentafluorbenzolsulfonat eingesetzt werden. Man erhält 12,7 g (65 % der Theorie) des oben genannten Komplexes: Schmelzpunkt 122°C.

Beispiel 4: ($\eta^6$-Cumol)($\eta^5$-cyclopentadienyl)eisen(II)-trifluoracetat:

Nach der in Beispiel 1 beschriebenen Methode hergestellt, wobei anstelle von Trifluormethansulfonsäure 5,4 g Natriumtrifluoracetat eingesetzt werden. Man erhält 9,7 g (68,5 % der Theorie) des oben genannten Komplexes als dunkelbraunes Oel mit einer Zersetzungstemperatur von mehr als 210°C.

Beispiel 5: ($\eta^6$-Stilben )($\eta^5$-cyclopentadienyl)eisen(II)-trifluormethansulfonat:

Man rührt eine Lösung von 10 g ($\eta^6$-Stilben)($\eta^5$-cyclopentadienyl)eisen(II)-hexafluorphosphat (Hergestellt gemäss Beispiel 2 der EP-A 207,889) und 3 g Aluminiumchlorid in 100 ml Methylenchlorid unter Stickstoff während 1 Stunde. Nach Zugabe von 160 ml Wasser wird 30 Minuten weitergerührt, danach die wässrige Phase im Scheidetrichter abgetrennt und langsam 3,66 g Trifluormethansulfonsäure zugetropft. Der entstandene Niederschlag wird abfiltriert, mit wenig Wasser nachgewaschen und im Vakuum bei 50 ° C getrocknet. Man erhält 4,24 g (42 % der Theorie) des oben genannten Komplexes: Schmelzpunkt: 130 ° C.

Beispiel 6: ($\eta^6$-Stilben)($\eta^5$-cyclopentadienyl)eisen(II)-4-toluolsulfonat

Nach der in Bsp. 5 beschriebenen Methode hergestellt, wobei anstelle von Trifluormethansulfonsäure 4,3 g 4-Toluolsulfonsäure eingesetzt werden. Man erhält 3,64 g (34,4 % der Theorie) des oben genannten Komplexes: Schmelzpunkt: 136 ° C.

Beispiel 7: ($\eta^6$-1-Methylnaphthalin)($\eta^5$-cyclopentadienyl)eisen(II)-trifluormethansulfonat

Nach der in Beispiel 1 beschriebenen Methode hergestellt, wobei anstelle von Cumol 35 ml 1-Methylnaphthalin eingesetzt werden. Man erhält 10,8 g (72 % der Theorie) des oben genannten Komplexes: Schmelzpunkt 78 ° C.

B) Anwendungsbeispiele

Beispiele I-III: Allgemeine Arbeitsvorschrift

Lösungen bestehend aus 100 g technischem Epoxidkresolnovolak (Epoxidwert 4,5 Aeq/kg), 50 g eines technischen Bisphenol-A-diglycidylethers (Epoxidwert 0,35 Aeq/kg), 30 g Talcum (Cyprus), 2 g Irgalithgrün (Ciba-Geigy), 180 g Cyclohexanon und den in Tabelle 1 angegebenen Mengen an Photoinitiator (Eisen-Aren-Komplex) und Sensibilisator werden mit einem 100 µ Drahtrakel auf eine Leiterplatte aufgebracht. Der vorerst nasse Film wird bei 80 ° C getrocknet. Die Belichtung der so hergestellten Platte erfolgt mit einer 5000-Watt Quecksilberhochdrucklampe im Abstand zur aufgelegten Maske von 50 cm. Die Belichtungszeit beträgt 1 Minute. Danach wird die Platte 10 Minuten bei 110 ° C vorgehärtet. Die Entwicklung erfolgt in Cyclohexanon, wobei die nicht belichteten Anteile (Lötaugen) gelöst werden. Danach wird die Platte 30 Minuten bei 135 ° C nachgehärtet. Die mit Flussmittel beschichtete Platte wird schlussendlich für 10 Sekunden in ein 270 ° C heisses Lötbad (Blei-Zinn) getaucht und anschliessend inspiziert (vgl. Tabelle 1).

Beispiele IV-VIII: Allgemeine Arbeitsvorschrift

Lösungen gemäss Beispielen I-III und Tabelle 2 werden mit einem 100 µ Drahtrakel auf 70 µ dicke Kupferfolien aufgetragen. Der Film wird 30 Minuten bei 80 ° C getrocknet, anschliessend 1 Minute belichtet (siehe Beispiele I-III) und 1 Stunde bei 135 ° C gehärtet.

Die Glasumwandlungstemperaturen der damit erhaltenen Schichten werden mittels thermomechanischer Analyse (Mettler, Messzelle TMA 40) ermittelt (vgl. Tabelle 2).

Tabelle 1

| Bsp. | Photoinitiator *) | Photoinitiator Konz. [mMol] | Sensibilisator | Sens. Konz. [mMol] | Aspekt nach Lötbad |
|---|---|---|---|---|---|
| I | [Cumol Fe Cp] $CF_3SO_3$ | 10 | Isopropylthioxanthon | 5 | keine Veränderung |
| II | [Cumol Fe Cp] $C_4F_9SO_3$ | 10 | Isopropylthioxanthon | 5 | keine Veränderung |
| III | [Stilben Fe Cp] $CF_3SO_3$ | 10 | - | - | keine Veränderung |

*) Cp = Cyclopentadienylanion

Tabelle 2

| Bsp. | Photoinitiator *) | Photoinitiator Konz. [mMol] | Sensibilisator | Sens. Konz. [mMol] | Tg (°C) |
|---|---|---|---|---|---|
| IV | [Cumol Fe Cp]$CF_3SO_3$ | 10 | Isopropylthioxanthon | 5 | 137 |
| V | [Cumol Fe Cp]$C_4F_9SO_3$ | 10 | Isopropylthioxanthon | 5 | 140 |
| VI | [Cumol Fe Cp]$C_6F_5SO_3$ | 10 | Isopropylthioxanthon | 5 | 162 |
| VII | [Stilben Fe Cp] $CF_3SO_3$ | 10 | - | - | 143 |
| VIII | [Naphtalin Fe Cp] $CF_3SO_3$ | 10 | - | - | 140 |

**Patentansprüche**

**Patentansprüche für folgende Vertragsstaaten : AT, BE, CH, LI, NL, SE**

1. Gemische enthaltend
   a) eine kationisch polymerisierbare Verbindung und
   b) eine Verbindung der Formel I

$$[R^1(Fe^{II}R^2)_a]_q^{\oplus an}\ an\ X^{\ominus q} \qquad (I),$$

   worin a 1 oder 2 ist, n 1 oder 2 darstellt, $R^1$ ein gegebenenfalls substituiertes $\pi$-Aren ist, $R^2$ ein gegebenenfalls substituiertes $\pi$-Aren oder Cyclopentadienylanion oder Indenylanion bedeutet, q eine ganze Zahl von 1 bis 3 ist und x $FSO_3^-$ oder ein q-wertiges Anion einer organischen Sulfonsäure oder einer Carbonsäure ist, mit der Massgabe, dass $R^1$ auch ein polyierer, aromatischer Ligand sein kann und dass in einem solchen Fall a eine Zahl ist, die der mittleren Anzahl der komplexierten Gruppen des Polymerliganden entspricht.

2. Gemische gemäss Anspruch 1, worin Komponente a) ein hochviskoses oder festes Epoxidharz ist.

3. Gemische gemäss Anspruch 1, worin $R^1$ ein monomeres $\pi$-Aren ist.

4. Gemische gemäss Anspruch 1, worin $X^{\ominus q}$ das einwertige Anion einer organischen Sulfonsäure ist.

5. Gemische gemäss Anspruch 4, worin $X^{\ominus q}$ das einwertige Anion einer aliphatischen, teilfluoraliphstischen oder perfluoraliphatischen Sulfonsäure oder einer aromatischen, teilfluoraromatischen oder perfluoraromatischen Sulfonsäure ist.

6. Gemische gemäss Anspruch 5, worin $X^{\ominus q}$ ausgewählt wird aus der Gruppe bestehend aus $CF_3SO_3^-$, $C_2F_5SO_3^-$, n-$C_3F_7SO_3^-$, n-$C_4F_9SO_3^-$, n-$C_6F_{13}SO_3^-$, n-$C_8F_{17}SO_3^-$ und $C_6F_5SO_3^-$.

7. Gemische gemäss Anspruch 1, enthaltend als Komponente b) eine Verbindung der Formel Ia

   $[R^1Fe^{II}R^2]^{\oplus n}\ n\ X^{\ominus}$ (Ia),

   worin $R^1$ ein $\pi$-Aren ist, $R^2$ ein $\pi$-Aren oder ein Cyclopentadienylanion bedeutet und $X^{\ominus}$ ein Anion einer organischen Sulfonsäure darstellt.

8. Gemische gemäss Anspruch 1, enthaltend als Komponente b) eine Verbindung der Formel I, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder Perfluorphenylsulfonat ist.

9. Gemische gemäss Anspruch 1, enthaltend als Komponente a) ein festes Epoxidharz und als Komponente b) eine Verbindung der Formel Ia gemäss Anspruch 7, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder ein Perfluorphenylsulfonat ist.

10. Verbindungen der Formel I gemäss Anspruch 1 mit Ausnahme von 1,4-Dimethylbenzol-cyclopentadienyl-eisen-(II)-trifluormethansulfonat und 9,9-Dimethylfluoren-cyclopentadienyl-eisen-(II)-fluorsulfonat.

11. Aktiviertes härtbares Gemisch erhältlich durch Bestrahlung eines Gemisches gemäss Anspruch 1 mit aktinischer Strahlung bei einer Temperatur, die unter der zum Heisshärten des härtbaren gemisches bei der Herstellung eines gehärtetet Produkts augewendeten liegt.

**12.** Gehärtetes Produkt erhältlich durch i) direktes Heisshärten eines härtbaren Gemisches gemäss Anspruch 1 oder ii) durch Bestrahlung eines härtbaren Gemisches gemäss Anspruch 1 mit aktinischem Licht und anschliessender Heisshärtung, wobei die Bestrahlungstemperatur unter der zum nachfolgenden Heisshärtern angewandten Temperatur liegt.

**13.** Verwendung der härtbaren Gemische gemäss Anspruch 1 zur Herstellung von Oberflächenbeschichtungen.

**14.** Verwendung der härtbaren Gemische gemäss Anspruch 2 zur Herstellung von Lötstoppmasken.

**Patentansprüche für folgende Vertragsstaaten DE, FR, GB, IT**

**1.** Gemische enthaltend
a) eine kationisch polymerisierbare Verbindung und
b) eine Verbindung der Formel I

$$[R^1(Fe^{II}R^2)_a]_q^{\oplus an}\ an\ X^{\ominus q} \qquad (I),$$

worin a 1 oder 2 ist, n 1 oder 2 darstellt, $R^1$ ein gegebenenfalls substituiertes $\pi$-Aren ist, $R^2$ ein gegebenenfalls substituiertes $\pi$-Aren oder Cyclopentadienylanion oder Indenylanion bedeutet, q eine ganze Zahl von 1 bis 3 ist und x $FSO_3^-$ oder ein q-wertiges Anion einer organischen Sulfonsäure oder einer Carbonsäure ist, mit der Massgabe, dass $R^1$ auch ein polymerer, aromatischer Ligand sein kann und dass in einem solchen Fall a eine Zahl ist, die der mittleren Anzahl der komplexierten Gruppen des Polymerliganden entspricht.

**2.** Gemische gemäss Anspruch 1, worin fromponente a) ein hochviskoses oder festes Epoxidharz ist.

**3.** Gemische gemäss Anspruch 1, worin $R^1$ ein monomeres $\pi$-Aren ist.

**4.** Gemische gemäss Anspruch 1, worin $X^{\ominus q}$ das einwertige Anion einer organischen Sulfonsäure ist.

**5.** Gemische gemäss Anspruch 4, worin $X^{\ominus q}$ das einwertige Anion einer aliphatischen, teilfluoraliphatischen oder perfluoraliphatischen Sulfonsäure oder einer aromatischen, teilfluoraromatischen oder perfluoraromatischen Sulfonsäure ist.

**6.** Gemische gemäss Anspruch 5, worin $X^{\ominus q}$ ausgewählt wird aus der Gruppe bestehend aus $CF_3SO_3^-$, $C_2F_5SO_3^-$, n-$C_3F_7SO_3^-$, n-$C_4F_9SO_3^-$, n-$C_6F_{13}SO_3^-$, n-$C_8F_{17}SO_3^-$ und $C_6F_5SO_3^-$.

**7.** Gemische gemäss Anspruch 1, enthaltend als Komponente b) eine Verbindung der Formel Ia

$[R^1Fe^{II}R^2]^{\oplus n}\ n\ X^{\ominus}$ (Ia),

worin $R^1$ ein $\pi$-Aren ist, $R^2$ ein $\pi$-Aren oder ein Cyclopentadienylanion bedeutet und $X^{\ominus}$ ein Anion einer organischen Sulfonsäure darstellt.

**8.** Gemische gemäss Anspruch 1, enthaltend als Komponente b) eine Verbindung der Formel I, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder Perfluorphenylsulfonat ist.

**9.** Gemische gemäss Anspruch 1, enthaltend als Komponente a) ein festes Epoxidharz und als Komponente b) eine Verbindung der Formel Ia gemäss Anspruch 7, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder ein Perfluorphenylsulfonat ist.

**10.** Aktiviertes härtbares Gemisch erhältlich durch Bestrahlung eines Gemisches gemäss Anspruch 1 mit aktinischer Strahlung bei einer Temperatur, die unter der zum Heisshärten des härtbaren Gemisches bei der Herstellung eines gehärteten Produkts angewendeten liegt.

**11.** Gehärtetes Produkt erhältlich durch i) direktes Heisshärten eines härtbaren Gemisches gemäss Anspruch 1 oder ii) durch Bestrahlung eines härtbaren Gemisches gemäss Anspruch 1 mit aktinischem Licht und anschliessender Heisshärtung, wobei die Bestrahlungstemperatur unter der zum nachfolgenden Heisshärtern angewandten Temperatur liegt.

**12.** Verwendung der härtbaren Gemische gemäss Anspruch 1 zur Herstellung von Oberflächenbeschichtungen.

**13.** Verwendung der härtbaren Gemische gemäss Anspruch 2 zur Herstellung von Lötstoppmasken.

**Patentansprüche für folgende Vertragsstaat : ES**

**1.** Gemische enthaltend
a) eine kationisch polymerisierbare Verbindung und
b) eine Verbindung der Formel I

$$[R^1(Fe^{II}R^2)_a]_q^{\oplus an}\ an\ X^{\ominus q} \qquad (I),$$

worin a 1 oder 2 ist, n 1 oder 2 darstellt, $R^1$ ein gegebenenfalls substituiertes $\pi$-Aren ist, $R^2$ ein gegebenenfalls substituiertes $\pi$-Aren oder Cyclopentadienylanion oder Indenylanion bedeutet, q eine ganze Zahl von 1 bis 3 ist und X $FSO_3^-$ oder ein q-wertiges Anion einer organischen Sulfonsäure oder einer Carbonsäure ist, mit der Massgabe, dass $R^1$ auch ein polymerer, aromatischer Ligand sein kann und dass in einem solchen Fall a eine Zahl ist, die der mittleren Anzahl der komplexierten Gruppen
des Polymerliganden entspricht.

**2.** Gemische gemäss Anspruch 1, worin Komponente a) ein hochviskoses oder festes Epoxidharz ist.

**3.** Gemische gemäss Anspruch 1, worin $R^1$ ein monomeres $\pi$-Aren ist.

**4.** Gemische gemäss Anspruch 1, worin $X^{\ominus q}$ das einwertige Anion einer organischen Sulfonsäure ist.

**5.** Gemische gemäss Anspruch 4, worin $X^{\ominus q}$ das einwertige Anion einer aliphatischen, teilfluoraliphatischen oder perfluoraliphatischen Sulfonsäure oder einer aromatischen, teilfluoraromatischen oder perfluoraromatischen Sulfonsäure ist.

**6.** Gemische gemäss Anspruch 5, worin $X^{\ominus q}$ ausgewählt wird aus der Gruppe bestehend aus $CF_3SO_3^-$, $C_2F_5SO_3^-$, n-$C_3F_7SO_3^-$, n-$C_4F_9SO_3^-$, n-$C_6F_{13}SO_3^-$, n-$C_8F_{17}SO_3^-$ und $C_6F_5SO_3^-$.

**7.** Gemische gemäss Anspruch 1, enthaltend als Komponente b) eine Verbindung der Formel Ia

$[R^1Fe^{II}R^2]^{\oplus n}$ n $X^{\ominus}$ (Ia),

worin $R^1$ ein $\pi$-Aren ist, $R^2$ ein $\pi$-Aren oder ein Cyclopentadienylanion bedeutet und $X^{\ominus}$ ein Anion einer organischen Sulfonsäure darstellt.

**8.** Gemische gemäss Anspruch 1, enthaltend als Komponente b) eine Verbindung der Formel I, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder Perfluorphenylsulfonat ist.

**9.** Gemische gemäss Anspruch 1, enthaltend als Komponente a) ein festes Epoxidharz und als Komponente b) eine Verbindung der Formel Ia gemäss Anspruch 7, worin $R^1$ ausgewählt wird aus der Gruppe bestehend aus Toluol, Xylol, Ethylbenzol, Cumol, Methoxybenzol, Methylnaphthalin, Methoxynaphthalin, Pyren, Perylen, Stilben, Diphenylenoxid und Diphenylensulfid, $R^2$ für ein Cyclopentadienylanion steht und $X^{\ominus}$ ein Perfluoralkylsulfonat oder ein Perfluorphenylsulfonat ist.

**10.** Verfahren zur Herstellung gehärteter Produkte, dadurch gekennzeichnet, dass man ein härtbares Gemisch enthaltend Komponenten a) und b) gemäss Anspruch 1 i) direkt heisshärtet oder ii) durch Bestrahlen mit aktinischem Licht und anschliessender Heisshärtung härtet, wobei die Bestrahlungstemperatur unter der zum nachfolgenden Heisshärten angewandten Temperatur liegt.

**11.** Aktiviertes härtbares Gemisch erhältlich durch Bestrahlung eines Gemisches gemäss Anspruch 1 mit aktinischer Strahlung bei einer Temperatur, die unter der zum nachfolgenden Heisshärten angewandten liegt.

**12.** Verwendung der härtbaren Gemische gemäss Anspruch 1 zur Herstellung von Oberflächenbeschichtungen.

**13.** Verwendung der härtbaren Gemische gemäss Anspruch 2 zur Herstellung von Lötstoppmasken.

**Claims**
**Claims for the following Contracting States : AT, BE, CH, LI, NL, SE**

**1.** A mixture containing
a) cationically polymerizable compound and
b) a compound of the formula I

$$[R^1(Fe^{II}R^2)_a]_q^{\oplus an} \; an \; X^{\ominus q} \qquad (I)$$

in which a is 1 or 2, n is 1 or 2, $R^1$ is a substituted or unsubstituted $\pi$-arene, $R^2$ is a substituted or unsubstituted $\pi$-arene or cyclopentadienyl anion or indenyl anion, q is an integer from 1 to 3 and X is $FSO_3^-$ or a q-valent anion of an organic sulfonic acid or carboxylic acid, subject to the proviso that $R^1$ can also be a polymeric, aromatic ligand and that in such a case a is a number corresponding to the average number of complexed groups in the polymer ligand.

**2.** A mixture according to claim 1, wherein component a) is a highly viscous or solid epoxide resin.

**3.** A mixture according to claim 1, wherein $R^1$ is a monomeric $\pi$-arene.

**4.** A mixture according to claim 1, wherein $X^{\ominus q}$ is the monovalent anion of an organic sulfonic acid.

**5.** A mixture according to claim 4, wherein $X^{\ominus q}$ is the monovalent anion of an aliphatic, partly fluorinated aliphatic or perfluorinated aliphatic sulfonic acid or of an aromatic, partly fluorinated aromatic or perfluorinated aromatic sulfonic acid.

**6.** A mixture according to claim 5, wherein $X^{\ominus q}$ is selected from the group consisting of $CF_3SO_3$, $C_2F_5SO_3$, $n\text{-}C_3F_7SO_3$, $n\text{-}C_4F_9SO_3$, $n\text{-}C_6E_{13}SO_3$, $n\text{-}C_8F_{17}SO_3$ and $C_6F_5SO_3$.

**7.** A mixture to claim 1, containing, as the component b), a compound of the formula Ia

$$[R^1Fe^{II}R^2]^{\oplus n} \; n \; X^{\ominus} \qquad (Ia)$$

in which R' is a $\pi$-arene, $R^2$ is a $\pi$-arene or a cyclopentadienyl anion and $X^{\ominus}$ is an anion of an organic sulfonic acid.

**8.** A mixture according to claim, containing, as the component b), a compound of the formula I in which $R^1$ is selected from the group consisting of toluene, xylene, ethylbenzene, cumene, methoxybenzene, methylnaphthalene, methoxynaphthalene, pyrene, perylene, stilbene, diphenylene oxide and diphenylene sulfide, $R^2$ is a cyclopentadienyl anion and $X^{\ominus}$ is a perfluoroalkylsulfonate or perfluorophenylsulfonate.

**9.** A mixture according to claim 1, containing, as the component a), a solid epoxide resin and, as the component b), a compound of the formula Ia according to claim 7 in which $R^1$ is selected from the group consisting of toluene, xylene, ethylbenzene, cumene, methoxybenzene, methylnapthalene, methoxynaphthalene, pyrene, perylene, stilbene, diphenylene oxide and diphenylene sulfide, $R^2$ is a cyclopentadienyl anion and $X^{\ominus}$ is a perfluoroalkylsulfonate or a perfluorophenylsulfonate.

**10.** A compound of the formula I according to claim 1, with the exception of 1,4-diemethylbenzene-cyclopentadienyl-iron (II) trifluoromethanesulfonate and 9,9-diemethylfluorenecyclopentadienyl-iron (II) fluosulfonate.

**11.** An activated curable mixture obtainable by irradiating a mixture according to claim 1 with actinic radiation at a temperature below that used for the curing by heat of the curable mixture in the production of a cured product.

**12.** A cured product obtainable by i) the direct curing by heat of a curable mixture according to claim 1, or ii) by irradiating a curable mixture according to claim 1 with actinic light and subsequently curing by heat, the irradiation temperature being below that used for the subsequent curing by heat.

**13.** Use of a curable mixture according to claim 1 for the production of surface coatings.

**14.** Use of a curable mixture according to claim 2 for the production of solder-stop masks.

**Claims for the Following Contracting States : DE, FR, GB, IT**

**1.** A mixture containing
a) a cationically polymerizable compound and
b) a compound of the formula I

$$[R^1(Fe^{II}R^2)_a]_q^{\oplus an}\ an\ X^{\ominus q} \quad (I)$$

in which a is 1 or 2, n is 1 or 2, $R^1$ is a substituted or unsubstituted $\pi$-arene, $R^2$ is a substituted or unsubstituted $\pi$-arene or cyclopentadienyl anion or indenyl anion, q is an integer from 1 to 3 and X is $FSO_3^-$ or a q-valent anion of an organic sulfonic acid or carboxylic acid, subject to the proviso that $R^1$ can also be a polymeric, aromatic ligand and that in such a case a is a number corresponding to the average number of complexed groups in the polymer ligand.

**2.** A mixture according to claim 1, wherein component a) is a highly viscous or solid epoxide resin.

**3.** A mixture according to claim 1, wherein $R^1$ is a monomeric $\pi$-arene.

**4.** A mixture according to claim 1, wherein $X^{\ominus q}$ is the monovalent anion of an organic sulfonic acid.

**5.** A mixture according to claim 4, wherein $X^{\ominus q}$ is the monovalent anion of an aliphatic, partly fluorinated aliphatic or perfluorinated aliphatic sulfonic acid or of an aromatic, partly fluorinated aromatic or perfluorinated aromatic sulfonic acid.

**6.** A mixture according to claim 5, wherein $X^{\ominus q}$ is selected from the group consisting of $CF_3SO_3^-$, $C_2F_5SO_3^-$, n-$C_3F_7SO_3^-$, n-$C_4F_9SO_3^-$, n-$C_6F_{13}SO_3^-$, n-$C_8F_{17}SO_3^-$ and $C_6F_5SO_3^-$.

**7.** A mixture according to claim 1, containing, as the component b), a compound of the formula Ia

$[R^1Fe^{II}R^2]^{\oplus n}$ n $X^{\ominus}$ (Ia)

in which $R^1$ is a $\pi$-arene, $R^2$ is a $\pi$-arene or a cyclopentadienyl anion and $X^{\ominus}$ is an anion of an organic sulfonic acid.

**8.** A mixture according to claim 1, containing, as the component b), a compound of the formula I in which $R^1$ is selected from the group consisting of toluene, xylene, ethylbenzene, cumene, methoxybenzene, methylnaphthalene, methoxynaphthalene, pyrene, perylene, stilbene, diphenylene oxide and diphenylene sulfide, $R^2$ is a cyclopentadienyl anion and $X^{\ominus}$ is a perfluoroalkylsulfonate or perfluorophenylsulfonate.

**9.** A mixture according to claim 1, containing, as the component a), a solid epoxide resin and, as the component b), a compound of the formula Ia according to claim 7 in which $R^1$ is selected from the group consisting of toluene, xylene, ethylbenzene, cumene, methoxybenzene, methylnaphthalene, methoxynaphthalene, pyrene, perylene, stilbene, diphenylene oxide and diphenylene sulfide, $R^2$ is a cyclopentadienyl anion and $X^{\ominus}$ is a perfluoroalkylsulfonate or a perfluorophenylsulfonate.

**10.** A process for the production of cured products, wherein a curable mixture containing components a) and b) according to claim 1 is (i) directly cured by heat, or (ii) cured by irradiation with actinic light and subsequent curing by heat, the irradiation temperature being below that used for the subsequent curing by heat.

**11.** An activated curable mixture obtainable by irradiating a mixture according to claim 1 with actinic radiation at a temperature below that used for the subsequent curing by heat.

**12.** Use of a curable mixture according to claim 1 for the production of surface coatings.

**13.** Use of a curable mixture according to claim 2 for the production of solder-stop masks.

**Claims for the following Contracting State : ES**

**1.** A mixture containing
a) a cationically polymerizable compound and
b) a compound of the formula I

$$[R^1(Fe^{II}R^2)_a]_q^{\oplus an} \text{ an } X^{\ominus q} \qquad (I)$$

in which a is 1 or 2, n is 1 or 2, $R^1$ is a substituted or unsubstituted $\pi$-arene, $R^2$ is a substituted or unsubstituted $\pi$-arene or cyclopentadienyl anion or indenyl anion, q is an integer from 1 to 3 and X is $FSO_3^-$ or a q-valent anion of an organic sulfonic acid or carboxylic acid, subject to the proviso that $R^1$ can also be a polymeric, aromatic ligand and that in such a case a is a number corresponding to the average number of complexed groups in the polymer ligand.

**2.** A mixture according to claim 1, wherein component a) is a highly viscous or solid epoxide resin.

**3.** A mixture according to claim 1, wherein $R^1$ is a monomeric $\pi$-arene.

**4.** A mixture according to claim 1, wherein $X^{\ominus q}$ is the monovalent anion of an organic sulfonic acid.

**5.** A mixture according to claim 4, wherein $X^{\ominus q}$ is the monovalent anion of an aliphatic, partly fluorinated aliphatic or perfluorinated aliphatic sulfonic acid or of an aromatic, partly fluorinated aromatic or perfluorinated aromatic sulfonic acid.

6. A mixture according to claim 5, wherein $X^{\ominus q}$ is selected from the group consisting of $CF_3SO_3^-$, $C_2F_5SO_3^-$, n-$C_3F_7SO_3^-$, n-$C_4F_9SO_3^-$, n-$C_6F_{13}SO_3^-$, n-$C_8F_{17}SO_3^-$ and $C_6F_5SO_3^-$.

7. A mixture according to claim 1, containing, as the component b), a compound of the formula Ia

$$[R^1Fe^{II}R^2]^{\oplus n}\ n\ X^{\ominus} \qquad (Ia)$$

in which $R^1$ is a $\pi$-arene, $R^2$ is a $\pi$-arene or a cyclopentadienyl anion and $X^{\ominus}$ is an anion of an organic sulfonic acid.

8. A mixture according to claim 1, containing, as the component b), a compound of the formula I in which $R^1$ is selected from the group consisting of toluene, xylene, ethylbenzene, cumene, methoxybenzene, methylnaphthalene, methoxynaphthalene, pyrene, perylene, stilbene, diphenylene oxide and diphenylene sulfide, $R^2$ is a cyclopentadienyl anion and $X^{\ominus}$ is a perfluoroalkylsulfonate or perfluorophenylsulfonate.

9. A mixture according to claim 1, containing, as the component a), a solid epoxide resin and, as the component b), a compound of the formula Ia according to claim 7 in which $R^1$ is selected from the group consisting of toluene, xylene, ethylbenzene, cumene, methoxybenzene, methylnaphthalene, methoxynaphthalene, pyrene, perylene, stilbene, diphenylene oxide and diphenylene sulfide, $R^2$ is a cyclopentadienyl anion and $X^{\ominus}$ is a perfluoroalkylsulfonate or a perfluorophenylsulfonate.

10. A process for the production of cured products, wherein a curable mixture containing components a) and b) according to claim 1 is (i) directly cured by heat, or (ii) cured by irradiation with actinic light and subsequent curing by heat, the irradiation temperature being below that used for the subsequent curing by heat.

11. An activated curable mixture obtainable by irradiating a mixture according to claim 1 with actinic radiation at a temperature below that used for the subsequent curing by heat.

12. Use of a curable mixture according to claim 1 for the production of surface coatings.

13. Use of a curable mixture according to claim 2 for the production of solder-stop masks.

**Revendications**
**Revendications pour les Etats contractants suivants : AT, BE, CH, LI, NL, SE**

1. Mélanges contenant :
   a) un composé polymérisable par voie cationique, et
   b) un composé de formule I

$$[R^1(Fe^{II}R^2)_a]_q^{\ominus an}\ an\ X^{\ominus q} \qquad (I),$$

(dans laquelle a vaut 1 ou 2; n vaut 1 ou 2; $R^1$ est un $\pi$-arène éventuellement substitué; $R^2$ représente un $\pi$-arène éventuellement substitué ou un anion cyclopentadiènyle ou un anion indényle; q est un nombre entier valant 1 à 3 et X représente $FSO_3^-$ ou un anion de valence q d'un acide sulfonique organique ou d'un acide carboxylique, avec la réserve que $R^1$ peut également représenter un ligand ou coordinat aromatique polymère et que, dans un tel cas, a est un nombre qui correspond au nombre moyen des groupes
complexés du ligand polymère.

2. Mélanges selon la revendication 1, dans lesquels le constituant (a) est une résine époxyde solide ou à viscosité élevée,

3. Mélanges selon la revendication 1, dans lesquels $R^1$ représente un $\pi$-arène monomère .

**4.** Mélanges selon la revendication 1, dans lesquels $X^{\ominus q}$ représente l'anion monovalent d'un acide sulfonique organique.

**5.** Mélanges selon la revendication 4, dans lesquels $X^{\ominus q}$ représente l'anion monovalent d'un acide sulfonique aliphatique partiellement fluoré ou aliphatique perfluoré ou d'un acide sulfonique aromatique, aromatique partiellement fluoré ou aromatique perfluoré.

**6.** Mélanges selon la revendication 5, dans lesquels $X^{\ominus q}$ est choisi dans l'ensemble consistant en $CF_3SO_3^-$ $C_2F_5SO_3^-$ n-$C_3F_7SO_3^-$, n-$C_4F_9SO_3^-$, n-$C_6F_{13}SO_3^-$ n-$C_8F_{17}SO_3$ et $C_6F_5SO_3$.

**7.** Mélanges selon la revendication 1, contenant comme constituant (b) un composé de formule Ia

$[R^1Fe^{II}R^2]^{\oplus n}$ n $X^-$ (Ia)

dans laquelle $R^1$ représente un groupe $\pi$-arène; $R^2$ représente un groupe $\pi$-arène ou un anion cyclopentadiènyle, et $X^-$ représente un anion d'un acide sulfonique organique.

**8.** Mélanges selon la revendication 1, contenant comme constituant (b) un composé de formule I, dans laquelle $R^1$ est choisi dans l'ensemble consistant en le toluène, le xylène, l'éthylbenzène, le cumène, du méthoxybenzène, du méthylnaphtalène, du méthoxynaphtalène, le pyrène, le pérylène, le stilbène, l'oxyde de diphénylène et le sulfure de diphénylène; $R^2$ représente un anion cyclopentadiènyle, et $X^-$ représente un perfluoro-alkyl-sulfonate ou un perfluorophénylsulfonate.

**9.** Mélanges selon la revendication 1, contenant comme constituant (a) une résine époxyde solide et, comme constituant (b) un composé de formule Ia selon la revendication 7 dans laquelle $R^1$ est choisi dans l'ensemble consistant en le toluène, le xylène, l'éthylbenzène, le cumène, du méthoxybenzène, du méthylnaphtalène, du méthoxynaphtalène, le pyrène, le pérylène, le stilbène, l'oxyde de diphénylène et le sulfure de diphénylène; $R^2$ représente un anion cyclopentadiènyle, et $X^-$ représente un perfluoro-alkyl-sulfonate ou un perfluorophénylsulfonate.

**10.** Composés de formule I selon la revendication, à l'exclusion du triflorométhane sulfonate de 1,4-diméthylbenzène-cyclopentadiènyle-fer-(II) et du fluorosulfonate de 9,9-diméthylfluorène-cyclopentadiènyle-fer-(II).

**11.** Mélanges durcissables activés, que l'on peut obtenir en soumettant un mélange selon la revendication I à une exposition à un éclairage ou à une irradiation par un rayonnement actinique à une température inférieure à celle appliquée pour faire durcir à chaud le mélange durcissable lors de la préparation d'un produit durci.

**12.** Produit durci que l'on peut obtenir par (i) durcissement direct à chaud d'un mélange durcissable selon la revendication 1, ou (ii) par exposition d'un mélange durcissable selon la revendication 1 à une lumière actinique, puis durcissement à chaud, la température de l'exposition à un éclairage ou un rayonnement se situant au-dessous de la température appliquée pour le durcissement subséquent à chaud.

**13.** Utilisation des mélanges durcis selon la revendication 1 pour produire des revêtements de surfaces.

**14.** utilisation des mélanges durcis selon la revendication 2 pour produire les masques de réserve pour brasage ou soudage.

**Revendications pour les Etats contractants suivants : DE, FR, GB, IT**

**1.** Mélanges contenant :
a) un composé polymérisable par voie cationique, et

b) un composé de formule I

$$[R^1(Fe^{II}R^2)_a]_q^{\ominus an} \quad an\ X^{\ominus q} \qquad (I),$$

(dans laquelle a vaut 1 ou 2; n vaut 1 ou 2; $R^1$ est un $\pi$-arène éventuellement substitué; $R^2$ représente un $\pi$-arène éventuellement substitué ou un anion cyclopentadiènyle ou un anion indényle; q est un nombre entier valant 1 à 3 et X représente $FSO_3^-$ ou un anion de valence q d'un acide sulfonique organique ou d'un acide carboxylique, avec la réserve que $R^1$ peut également représenter un ligand ou coordinat aromatique polymère et que dans un tel cas, a est un nombre qui correspond au nombre moyen des groupes complexés du ligand polymère.

**2.** Mélanges selon la revendication 1, dans lesquels le constituant (a) est une résine époxyde solide ou à viscosité élevée,

**3.** Mélanges selon la revendication 1, dans lesquels $R^1$ représente un $\pi$-arène monomère .

**4.** Mélanges selon la revendication 1, dans lesquels $X^{\ominus q}$ représente l'anion monovalent d'un acide sulfonique organique.

**5.** Mélanges selon la revendication 4, dans lesquels $X^{\ominus q}$ représente l'anion monovalent d'un acide sulfonique aliphatique partiellement fluoré ou aliphatique perfluoré ou d'un acide sulfonique aromatique, aromatique partiellement fluoré ou aromatique perfluoré.

**6.** Mélanges selon la revendication 5, dans lesquels $X^{\ominus q}$ est choisi dans l'ensemble consistant en $CF_3SO_3^-$, $C_2F_5SO_3^-$, n-$C_3F_7SO_3$ , n-$C_4F_9SO_3^-$, n-$C_6F_{13}SO_3^-$, n-$C_8F_{17}SO_3^-$ et $C_6F_5SO_3^-$.

**7.** Mélanges selon la revendication 1, contenant comme constituant (b) un composé de formule Ia

$[R^1Fe^{II}R^2]\oplus^n$ n $X^\ominus$ (Ia)

dans laquelle $R^1$ représente un groupe $\pi$-arène; R2 représente un groupe $\pi$-arène ou un anion cyclopentadiènyle, et X - représente un anion d'un acide sulfonique organique.

**8.** Mélanges selon la revendication 1, contenant comme constituant (b) un composé de formule I, dans laquelle $R^1$ est choisi dans l'ensemble consistant en le toluène, le xylène, l'éthylbenzène, le cumène, du méthoxybenzène, du méthylnaphtalène, du méthoxynaphtalène, le pyrène, le pérylène, le stilbène, l'oxyde de diphénylène et le sulfure de diphénylène; $R^2$ représente un anion cyclopentadiènyle, et $X^-$ représente un perfluoro-alkyl-sulfonate ou un perfluorophénylsulfonate.

**9.** Mélanges selon la revendication 1, contenant comme constituant (a) une résine époxyde solide et, comme constituant (b) un composé de formule Ia selon la revendication 7 dans laquelle $R^1$ est choisi dans l'ensemble consistant en le toluène, le xylène, l'éthylbenzène, le cumène, du méthoxybenzène, du méthylnaphtalène, du méthoxynaphtalène, le pyrène, le pérylène, le stilbène, l'oxyde de diphénylène et le sulfure de diphénylène; $R^2$ représente un anion cyclopentadiènyle, et $X^-$ représente un perfluoro-alkyl-sulfonate ou un perfluorophénylsulfonate.

**10.** Mélange durcissable activé, que l'on peut obtenir par exposition d'un mélange selon la revendication 1, à un éclairage ou irradiation par un rayonnement actinique à une température au-dessous de la température appliquée, lors de la production d'un produit durci, pour faire durcir le mélange durcissable.

**11.** Produit durci, que l'on peut obtenir par (i) durcissement direct à chaud d'un mélange durcissable selon la revendication 1, ou (ii) par exposition d'un mélange durcissable selon la revendication 1 à un rayonnement de lumière actinique, puis durcissement à chaud, la température de cette exposition à un rayonnement se situant au-dessous de la température appliquée lors du durcissement subséquent à

chaud.

12. Utilisation des mélanges durcissables selon la revendication 1 pour produire des revêtements de surfaces.

13. Utilisation des mélanges durcissables selon la revendication 2 pour produire des masques de réserve pour soudage ou brasage.

**Revendications pour l'Etats contractant suivant : ES**

1. Mélanges contenant :
   a) un composé polymérisable par voie cationique, et
   b) un composé de formule I

$$[R^1(Fe^{II}R^2)_a]_q^{\ominus an}\ an\ X^{\ominus q} \qquad (I),$$

(dans laquelle a vaut 1 ou 2; n vaut 1 ou 2; R1 est un $\pi$-arène éventuellement substitué; $R^2$ représente un $\pi$-arène éventuellement substitué ou un anion cyclopentadiènyle ou un anion indényle; q est un nombre entier valant 1 à 3 et X représente $FSO_3^-$ ou un anion de valence q d'un acide sulfonique organique ou d'un acide carboxylique, avec la réserve que $R^1$ peut également représenter un ligand ou coordinat aromatique polymère et que dans un tel cas, a est un nombre qui correspond au nombre moyen des groupes complexés du ligand polymère.

2. Mélanges selon la revendication 1, dans lesquels le constituant (a) est une résine époxyde solide ou à viscosité élevée,

3. Mélanges selon la revendication 1, dans lesquels $R^1$ représente un $\pi$-arène monomère .

4. Mélanges selon la revendication 1, dans lesquels $X^{\ominus q}$ représente l'anion monovalent d'un acide sulfonique organique.

5. Mélanges selon la revendication 4, dans lesquels $X^{\ominus q}$ représente l'anion monovalent d'un acide sulfonique aliphatique partiellement fluoré ou aliphatique perfluoré ou d'un acide sulfonique aromatique, aromatique partiellement fluoré ou aromatique perfluoré.

6. Mélanges selon la revendication 5, dans lesquels $X^{\ominus q}$ est choisi dans l'ensemble consistant en $CF_3SO_3^-$, $C_2F_5SO_3^-$, n-$C_3F_7SO_3^-$ n-$C_4F_9SO_3^-$ n-$C_6F_{13}SO_3^-$, n-$C_8F_{17}SO_3^-$ et $C_6F_5SO_3^-$.

7. Mélanges selon la revendication 1, contenant comme constituant (b) un composé de formule Ia

$[R^1Fe^{II}R^2]^{\oplus n}\ n\ X^-$ (Ia)

dans laquelle $R^1$ représente un groupe $\pi$-arène; $R^2$ représente un groupe $\pi$-arène ou un anion cyclopentadiènyle, et X - représente un anion d'un acide sulfonique organique.

8. Mélanges selon la revendication 1, contenant comme constituant (b) un composé de formule I, dans laquelle $R^1$ est choisi dans l'ensemble consistant en le toluène, le xylène, l'éthylbenzène, le cumène, du méthoxybenzène, du méthylnaphtalène, du méthoxynaphtalène, le pyrène, le pérylène, le stilbène, l'oxyde de diphénylène et le sulfure de diphénylène; $R^2$ représente un anion cyclopentadiènyle, et $X^-$ représente un perfluoro-alkyl-sulfonate ou un perfluorophénylsulfonate.

9. Mélanges selon la revendication 1, contenant comme constituant (a) une résine époxyde solide et, comme constituant (b) un composé de formule Ia selon la revendication 7 dans laquelle $R^1$ est choisi dans l'ensemble consistant en le toluène, le xylène, l'éthylbenzène, le cumène, du méthoxybenzène, du méthylnaphtalène, du méthoxynaphtalène, le pyrène, le pérylène, le stilbène, l'oxyde de diphénylène et

le sulfure de diphénylène; $R^2$ représente un anion cyclopentadiènyle, et $X^-$ représente un perfluoroalkyl-sulfonate ou un perfluorophénylsulfonate.

**10.** Procédé pour préparer des produits durcis, caractérisés en ce qu'on soumet un mélange durcissable, contenant des constituants (a) et (b) selon la revendication 1 (i) à un durcissement direct à chaud, ou (ii) à une exposition à un rayonnement de lumière actinique puis à un durcissement à chaud, la température de l'exposition à un rayonnement se situant au-dessous de la température appliquée lors du durcissement à chaud subséquent.

**11.** Mélange durcissable activé, que l'on peut obtenir en soumettant un mélange selon la revendication 1 à une exposition à un rayonnement actinique, à une température qui se situe au-dessous de celle appliquée pour le durcissement subséquent à chaud.

**12.** Utilisation des mélanges durcissables selon la revendication 1, pour produire des revêtements sur des surfaces.

**13.** Utilisation des mélanges durcissables selon la revendication 2 pour produire des masques de réserve pour soudage et/ou brasage.